# EUROPEAN PATENT APPLICATION

(11) **EP 4 826 349 A1**
(43) Date of publication of application: **21.10.2026**
(21) Application number: 24914819.8
(22) Date of filing: 13.08.2024
(51) Int. Cl.: G01M 3/32

(54) **BATTERY AIRTIGHTNESS TESTING SYSTEM AND METHOD**

(30) Priority: 02.01.2024 CN 202410004826
(71) Applicant: Contemporary Amperex Technology Co., Limited, Ningde, Fujian 352100 (CN)
(72) Inventor: SHI, Deqiang, Ningde, Fujian 352100 (CN); LAN, Bin, Ningde, Fujian 352100 (CN); GUO, Jianfeng, Ningde, Fujian 352100 (CN)
(74) Representative: Kraus & Lederer PartGmbB
(86) International application number: PCT/CN2024/111653
(87) International publication number: WO 2025/145597

(57) **Abstract**

The present application provides a battery airtightness testing system and method. The battery airtightness testing system comprises an initial test module and at least two re-test modules. The initial test module is configured to perform a first airtightness test on a plurality of incoming battery packs; each incoming battery pack comprises a plurality of batteries; and the battery packs tested by the initial test module include a first compliant battery pack and a first non-compliant battery pack. The re-test module comprises a buffer platform, a re-test chamber, and a re-test manipulator; the buffer platform is configured to receive and store the first non-compliant battery pack; the re-test manipulator is configured to grab all batteries in the first non-compliant battery pack buffered in the buffer platform into the re-test chamber; the re-test chamber is configured to perform an independent second airtightness test on each battery in the first non-compliant battery pack; and the batteries tested by the re-test chamber include a second compliant battery and a second non-compliant battery.

## Description

### CROSS-REFERENCE TO RELATED APPLICATION

The present application claims priority to Chinese patent application 202410004826.9 titled "BATTERY AIRTIGHTNESS TESTING SYSTEM AND METHOD" and filed on January 02, 2024, which is incorporated herein in its entirety by reference.

### TECHNICAL FIELD

The present application relates to the technical field of batteries, and in particular, to a battery airtightness testing system and method.

### BACKGROUND

If the lithium battery casing is poorly sealed during use of the lithium battery, problems such as leakage and swelling may occur, posing certain safety hazards for use of the lithium battery. Therefore, the airtightness testing of lithium batteries is an important part of the lithium battery production process.

As a crucial part in the lithium battery production process, improving the efficiency of lithium battery airtightness testing is an urgent problem to be solved.

### SUMMARY OF THE INVENTION

In view of the above problems, the present application provides a battery airtightness testing system and method to improve testing efficiency.

In a first aspect, the present application provides a battery airtightness testing system. The battery airtightness testing system comprises an initial test module and at least two re-test modules. The initial test module is configured to perform a first airtightness test on a plurality of incoming battery packs; each incoming battery pack comprises a plurality of batteries; and the battery packs tested by the initial test module include a first compliant battery pack and a first non-compliant battery pack. All batteries in the first compliant battery pack have passed the first airtightness test, and at least one battery in the first non-compliant battery pack has failed the first airtightness test. The re-test module comprises a buffer platform, a re-test chamber, and a re-test manipulator; the buffer platform is configured to receive and buffer the first non-compliant battery pack; the re-test manipulator is configured to grab all batteries in the first non-compliant battery pack buffered in the buffer platform into the re-test chamber; the re-test chamber is configured to perform an independent second airtightness test on each battery in the first non-compliant battery pack; and the batteries tested by the re-test chamber include a second compliant battery and a second non-compliant battery.

In the technical solution of the present application, at least two re-test modules are provided to perform a second airtightness test on the batteries in the first non-compliant battery pack. The at least two re-test modules operate in parallel, thereby improving the re-test processing capability of the battery airtightness testing system and increasing production efficiency. Furthermore, each re-test module includes its own re-test manipulator, which allows the at least two re-test chambers to operate simultaneously and in parallel, avoiding the problem that the limited number of re-test manipulators allows the at least two re-test chambers only to operate in sequence, thus further improving testing efficiency.

In some embodiments, the re-test module further includes a re-test pairing platform, and the re-test manipulator is configured to grab the second compliant batteries into the re-test pairing platform to pair them into groups.

The re-test module in embodiments of the present application is provided with a re-test pairing platform that is independent of the buffer platform. This allows the buffer operation and the pairing operation to run independently, reducing conflicts in the action flow and improving the fault tolerance rate.

In some embodiments, the battery airtightness testing system further includes a first unloading manipulator and a first-stage unloading conveyor belt. The first unloading manipulator is configured to grab a second compliant battery pack onto the first-stage unloading conveyor belt after a plurality of second compliant batteries are paired on the re-test pairing platform to form the second compliant battery pack.

The embodiments of the present application provide a re-test manipulator and a first-stage unloading manipulator to perform the re-test and unloading operations respectively, which allows the re-test and unloading operations to be carried out in parallel, improving the overall production rhythm and production efficiency.

In some embodiments, the first unloading manipulator is further configured to grab the first compliant battery pack onto the first-stage unloading conveyor belt and grab the first non-compliant battery pack onto the buffer platform.

The first unloading manipulator in the embodiments of the present application is configured to transfer the incoming battery pack that has undergone the first airtightness test to the next process according to the test results, which is a simple processing flow.

In some embodiments, the at least two re-test modules include a first re-test module and a second re-test module that are arranged opposite to each other.

The at least two re-test modules in the embodiments of the present application are arranged opposite to each other, which allows a compact structure of the battery airtightness testing system in the embodiments of the present application. Moreover, this ensures that the movement path of the first unloading manipulator remains basically the same regardless of whether the first non-compliant battery pack output from the initial test module is transferred to the first re-test module for the second airtightness test or to the second re-test module for the second airtightness test, thereby reducing the complexity of the control method.

In some embodiments, the battery airtightness testing system further includes at least two non-compliant battery conveyor belts, which are provided in correspondence with the at least two re-test modules, and the re-test manipulator is configured to grab the second non-compliant batteries onto the at least two non-compliant battery conveyor belts.

The battery airtightness testing system in the embodiments of the present application has at least two non-compliant battery conveyor belts, each corresponding to one re-test module. This allows for flexible handling of batteries that have failed the test of the re-test module, increases the total buffer capacity, and enhances the waste disposal capacity.

In some embodiments, the initial test module includes a plurality of initial test chambers, which are provided in correspondence with a plurality of incoming battery packs so that each initial test chamber is configured to perform a first airtightness test on the plurality of batteries in the incoming battery packs.

The initial test module of the embodiments of the present application includes a plurality of initial test chambers, each corresponding to one incoming battery pack. In this way, the plurality of transported incoming battery packs may be transferred to the plurality of initial test chambers for the first airtightness test, thereby improving the processing capacity of the battery airtightness testing system of the embodiments of the present application.

In some embodiments, the battery airtightness testing system includes at least two initial test modules and a loading manipulator. The at least two initial test modules include a first initial test module and a second initial test module. The loading manipulator is configured to load a plurality of incoming battery packs into the first initial test module and the second initial test module, the second initial test module being loaded only when the at least two initial test chambers of the first initial test module are both full.

In the embodiments of the present application, the loading manipulator determines whether the first initial test module is full before loading. Only when the first initial test module is full will it load the second initial test module. This avoids vacant space in the initial test chamber of the initial test module, thereby ensuring processing efficiency.

In some embodiments, the battery airtightness testing system further includes a compliant battery unloading conveyor belt, a withstand voltage test conveyor belt disposed downstream of the compliant battery unloading conveyor belt, a second unloading manipulator, and an unloading pairing platform. The compliant battery unloading conveyor belt is configured to receive batteries that have passed the airtightness test. The batteries that have passed the airtightness test include a plurality of batteries in a first compliant battery pack and a second compliant battery. The withstand voltage test conveyor belt is configured to perform a withstand voltage test on the batteries that have passed the airtightness test. The second unloading manipulator is configured to grab at least two batteries from the withstand voltage test conveyor belt and place the batteries that have passed the withstand voltage test on the unloading pairing platform according to the test results of the withstand voltage test conveyor belt. The unloading pairing platform is configured to receive the batteries that have passed the withstand voltage test and pair them into groups.

With the battery airtightness testing system of the embodiments of the present application, through the cooperation of the second unloading manipulator and the unloading pairing platform, batteries that have passed the withstand voltage test are paired and buffered on the unloading pairing platform, while batteries that have failed the withstand voltage test are directly disposed of by the second unloading manipulator. This setting improves the effectiveness of the process and reduces the waste of the pull belt buffer position.

In some embodiments, the second unloading manipulator includes at least two grabbing parts arranged in correspondence with at least two batteries. The at least two grabbing parts are arranged sequentially in the arrangement direction of the at least two batteries. The at least two batteries include a battery that has passed the withstand voltage test and a battery that has failed the withstand voltage test. The second unloading manipulator is configured to control the grabbing part configured to grab the battery that has passed the withstand voltage test to open and place the battery that has passed the withstand voltage test onto the unloading pairing platform, and to control the grabbing part configured to grab the battery that has failed the withstand voltage test to close and continue grabbing batteries that have failed the withstand voltage test.

The second unloading manipulator in the embodiments of the present application simultaneously grabs a battery that has passed the withstand voltage test and a battery that has failed the withstand voltage test, thus avoiding repeated grabbing and improving efficiency. It also avoids buffering a battery that has failed the withstand voltage test on the pull belt, reducing the waste of pull belt buffer position.

In some embodiments, the unloading pairing platform includes a platform body and a lifting mechanism. The platform body is configured to hold a battery that has passed the withstand voltage test placed by the second unloading manipulator. When there is an empty space between a plurality of batteries that have passed the withstand voltage test, the lifting mechanism lifts at least some of the plurality of batteries that have passed the withstand voltage test upward and moves them laterally so that the plurality of batteries that have passed the withstand voltage test are arranged sequentially on the platform body.

The unloading pairing platform of the embodiments of the present application uses a lifting mechanism to lift and translate the batteries to fill the empty space in the platform main body, thereby completing the ordering and pairing of a plurality of batteries to facilitate the battery pack discharge process.

In some embodiments, the battery airtightness testing system further includes a loading barcode scanning conveyor belt, which is configured to scan the barcode of various batteries in the incoming battery pack before loading the incoming battery pack into the initial test module.

The battery airtightness testing system of the embodiments of the present application performs barcode scanning on the incoming battery pack before loading. However, barcode-scanning based disposal is not performed on a battery that has failed the barcode scanning before loading. This avoids the waste of the process caused by barcode-scanning based disposal of the entire group of batteries if some batteries in the group have failed the barcode scanning. This alleviates the problem of low efficiency caused by repeated testing.

In some embodiments, the battery airtightness testing system further includes a compliant battery unloading conveyor belt, a second unloading manipulator, and an unloading pairing platform. The compliant battery unloading conveyor belt is configured to receive batteries that have passed the airtightness test. The second unloading manipulator is configured to transport the batteries that have passed the airtightness test according to the barcode scanning results of the loading barcode scanning conveyor belt. The second unloading manipulator transports the batteries that have passed barcode scanning to the unloading pairing platform to pair them into groups.

The battery airtightness testing system of the embodiments of the present application does not perform barcode-scanning based disposal immediately after scanning the barcode of the incoming battery pack. Instead, it performs barcode-scanning based disposal only on a battery that has passed the airtightness test. This avoids repeated testing and improves efficiency.

In a second aspect, the present application provides a battery airtightness testing method based on the above-mentioned battery airtightness testing system, the battery airtightness testing method comprising the following steps:

controlling the initial test module to operate to perform a first airtightness on a plurality of incoming battery packs, the battery packs tested by the initial test module including a first compliant battery pack and a first non-compliant battery pack, all batteries in the first compliant battery pack having passed the first airtightness test, and at least one battery in the first non-compliant battery pack having failed the first airtightness test; and grabbing various batteries in the first non-compliant battery pack into a re-test chamber of at least two re-test modules for an independent second airtightness test, the batteries tested by the re-test chamber including a second compliant battery and a second non-compliant battery.

In the battery airtightness testing method of the embodiments of the present application, at least two re-test modules are used to perform a second airtightness test on the batteries in the first non-compliant battery pack. The at least two re-test modules operate in parallel, thereby improving the re-test processing capability of the battery airtightness testing system and increasing production efficiency.

In some embodiments, the battery airtightness testing system includes a first initial test module and a second initial test module, and the battery airtightness testing method further includes: loading a plurality of incoming battery packs into the first initial test module and the second initial test module, the second initial test module being loaded only when at least two initial test chambers of the first initial test module are both full.

In the embodiments of the present application, the loading manipulator determines whether the first initial test module is full before loading. Only when the first initial test module is full will it load the second initial test module. This avoids vacant space in the initial test chamber of the initial test module, thereby ensuring processing efficiency.

In some embodiments, the battery airtightness testing method includes scanning the barcode of various batteries in the incoming battery pack before loading the incoming battery pack into the initial test module.

The battery airtightness testing system of the embodiments of the present application performs barcode scanning on the incoming battery pack before loading. However, barcode-scanning based disposal is not performed on a battery that has failed the barcode scanning before loading. This avoids the waste of the process caused by barcode-scanning based disposal of the entire group of batteries if some batteries in the group have failed the barcode scanning. This alleviates the problem of low efficiency caused by repeated testing.

In some embodiments, the battery airtightness testing method further includes: after completing the second airtightness test, disposing of a battery that has failed the barcode scanning among the second compliant batteries according to the barcode scanning results of various batteries in the incoming battery pack.

The battery airtightness testing system of the embodiments of the present application does not perform barcode-scanning based disposal immediately after scanning the barcode of the incoming battery pack. Instead, it performs barcode-scanning based disposal only on a battery that has passed the airtightness test. This avoids repeated testing and improves efficiency.

The description above is only an overview of the technical solutions of the present application. In order to better understand the technical means of the present application and thus implement them according to the contents of the specification, and in order to make the aforementioned and other objectives, features, and advantages of the present application more obvious and understandable, detailed description of the present application will be made specifically below.

### DESCRIPTION OF DRAWINGS

In order to more clearly illustrate the technical solutions of the embodiments of the present application, the drawings required in the embodiments of the present application will be described briefly below. Apparently, the drawings described below depict merely some embodiments of the present application. For those of ordinary skill in the art, other drawings may also be obtained according to these drawings without any creative effort.
FIG. 1 is a structural block diagram of a battery airtightness testing system according to some embodiments of the present application;
FIG. 2 is a schematic structural diagram of a state of an unloading pairing platform according to some embodiments of the present application;
FIG. 3 is a schematic structural diagram of another state of an unloading pairing platform according to some embodiments of the present application; and
FIG. 4 is a schematic flowchart of a battery airtightness testing method according to some embodiments of the present application.

In the accompanying drawings, the accompanying drawings are not drawn to actual scale.

### Description of reference numerals:

loading rotation conveyor belt 100;
loading barcode scanning conveyor belt 200;
loading transfer conveyor belt 300;
loading conveyor belt 400;
loading manipulator 500;
initial test module 600, first initial test module 600a, second initial test module 600b;
first unloading manipulator 700;
first-stage unloading conveyor belt 800;
withstand voltage test conveyor belt 900;
unloading buffer conveyor belt 1000;
unloading rotation conveyor belt 1100;
second-stage unloading conveyor belt 1200;
unloading pairing platform 1300, platform body 13001, lifting mechanism 13002, translation mechanism 13003;
second unloading manipulator 1400;
buffer unloading conveyor belt 1500;
buffer platform 1600;
re-test pairing platform 1700;
re-test chamber 1800;
non-compliant battery conveyor belt 1900;
re-test manipulator 2000.

### DETAILED DESCRIPTION

Unless otherwise defined, all technical and scientific terms used herein have the same meaning as commonly understood by those skilled in the art belonging to the technical field of the present application. The terms used herein are intended only for the purpose of describing specific embodiments and are not intended to limit the present application. The terms "including" and "having" and any variations thereof in the specification and the claims of the present application and in the description of drawings above are intended to cover non-exclusive inclusion.

In the description of the embodiments of the present application, the technical terms "first", "second", and the like are used only to distinguish between different objects, and are not to be understood as indicating or implying relative importance or implicitly specifying the number, particular order, or primary and secondary relation of the technical features indicated. In the description of the embodiments of the present application, the meaning of "a plurality of" is two or more, unless otherwise explicitly and specifically defined.

Reference to "an embodiment" herein means that a particular feature, structure, or characteristic described with reference to an embodiment may be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiment of the present application, the term "and/or" is merely an association that describes the associated object, indicating that there may be three kinds of relationships, such as A and/or B, which may be denoted as: the existence of A alone, the existence of both A and B, and the existence of B alone. Moreover, the character "/" herein generally indicates that the context objects are in an "or" relationship.

In the description of the embodiments of the present application, the term "a plurality of" refers to more than two (including two), and similarly, "a plurality of groups" refers to more than two groups (including two groups); and "a plurality of sheets" refers to more than two sheets (including two sheets).

In the description of the embodiments of the present application, the orientation or positional relationships indicated by the technical terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or positional relationships shown in the accompanying drawings, and are only for convenience of description of the present application and simplification of the description, rather than indicating or implying that the indicated apparatus or element must have a specific orientation, be constructed and operate in a specific orientation, and therefore, may not be understood as a limitation to the present application.

In the description of the embodiments of the present application, unless otherwise expressly specified or defined, the technical terms "mounted", "linked", "connected", "fixed" and other terms shall be understood broadly, for example, they may be fixed, detachable, or integral, or mechanically or electrically connected, or directly linked, or indirectly linked through an intermediate medium, and may be communicated internally or interacted between two elements. For those of ordinary skill in the art, the specific meanings of the above terms in the embodiments of the present application may be understood according to specific situations.

A battery generally includes a casing, a top cover and an electrode assembly accommodated in the casing. The casing and top cover are welded together to ensure the sealing of the battery. To ensure that the sealing of the battery meets requirements, the welding quality between the casing and the top cover is required to be tested. Battery airtightness testing systems are typically used to test the airtightness of batteries.

The testing efficiency of battery airtightness testing systems in related art is low and may not meet higher production requirements.

To improve testing efficiency, an embodiment of the present application provide a battery airtightness testing system. The battery airtightness testing system of this embodiment has at least two re-test modules. In this way, a plurality of batteries in a battery pack that has failed the test of the initial test module may be re-tested by the at least two re-test modules. The at least two re-test modules operate in parallel, thereby improving the re-test processing capability of the battery airtightness testing system and increasing production efficiency.

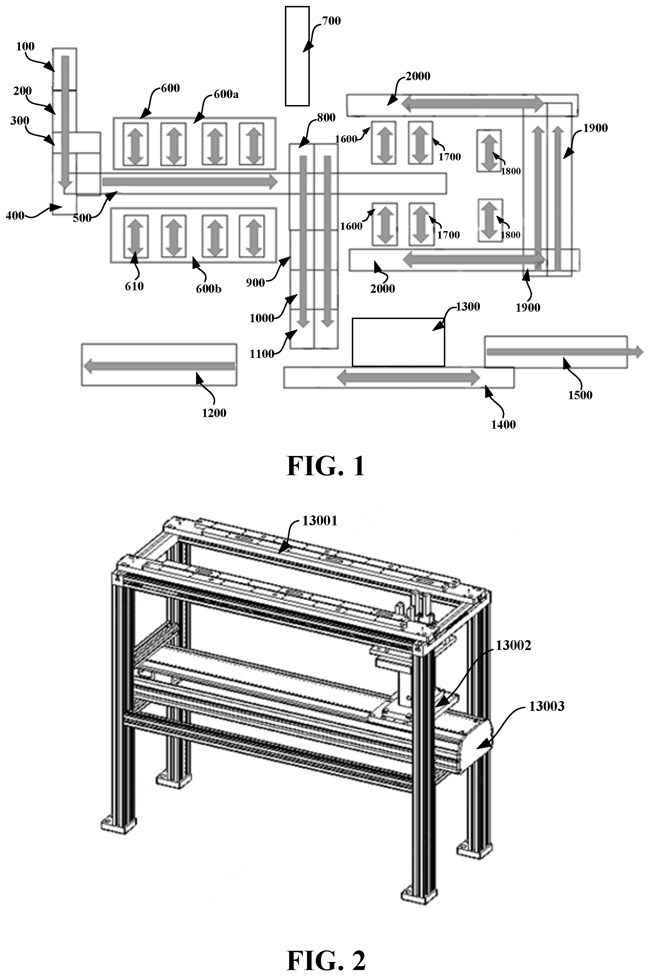

Referring to FIG. 1, the battery airtightness testing system of some embodiments of the present application includes an initial test module 600 and at least two re-test modules. The initial test module 600 is configured to perform a first airtightness test on a plurality of incoming battery packs. Each incoming battery pack consists of a plurality of batteries. The battery packs that have been tested by the initial test module 600 include a first compliant battery pack and a first non-compliant battery pack. All batteries in the first compliant battery pack have passed the first airtightness test. At least one battery in the first non-compliant battery pack has failed the first airtightness test. The re-test module includes a buffer platform 1600, a re-test chamber 1800, and a re-test manipulator 2000. The buffer platform 1600 is configured to receive and store the first non-compliant battery pack. The re-test manipulator 2000 is configured to grab all the batteries from the first non-compliant battery pack buffered on the buffer platform 1600 into the re-test chamber 1800. The re-test chamber 1800 is configured to perform an independent second airtightness test on each battery in the first non-compliant battery pack; and the batteries tested by the re-test chamber 1800 include a second compliant battery and a second non-compliant battery.

The initial test module 600 of the embodiments of the present application is configured to perform a first airtightness test on a plurality of incoming battery packs. An incoming battery pack refers to a plurality of batteries being transported in a group. For example, four batteries form one incoming battery pack, which is then gripped and loaded by a manipulator or other gripping tools. In a specific embodiment, an incoming battery pack consisting of four batteries is used as an example for illustration. It is understood that five batteries or six batteries may also be tested as a group, or another number of batteries form a group, which is not limited here. On the other hand, the initial test module 600 in the embodiments of the present application performs the first airtightness test on a group of batteries simultaneously. If all the batteries in an incoming battery pack have passed the airtightness test, then the incoming battery pack is determined to be the first compliant battery pack. If any battery in an incoming battery pack fails the airtightness test, then the incoming battery pack is determined to be the first non-compliant battery pack.

In the specific embodiment shown in FIG. 1, the initial test module 600 includes four initial test chambers 610. Each initial test chamber 610 is configured to test the airtightness of an incoming battery pack. In some other embodiments, the initial test module 600 may include any number of initial test chambers 610.

After the first airtightness test is performed by the initial test module 600, the buffer platform 1600 is configured to receive and store the first non-compliant battery pack. Since at least one battery in the first non-compliant battery pack has failed the airtightness test, a second airtightness test is further required for each battery. The re-test manipulator 2000 is configured to grab the batteries from the first non-compliant battery pack on the buffer platform 1600 into the re-test chamber 1800 for the second airtightness test. In order to accurately identify batteries that have failed the airtightness test, the re-test chamber 1800 performs an independent test on each battery in the first non-compliant battery during the second airtightness test. For example, in some embodiments, the re-test chamber 1800 includes at least two sub-retest chambers, each configured to perform an airtightness test on a single battery. After the re-test chamber 1800 completes the test, it may identify the second compliant battery and the second non-compliant battery. This allows for the direct disposal of the second non-compliant battery.

In the technical solution of the embodiments of the present application, at least two re-test modules are provided to perform a second airtightness test on the batteries in the first non-compliant battery pack. The at least two re-test modules operate in parallel, thereby improving the re-test processing capability of the battery airtightness testing system and increasing production efficiency. Furthermore, each re-test module includes its own re-test manipulator 2000, which allows at least two re-test chambers 1800 to operate simultaneously and in parallel, avoiding the problem that the limited number of re-test manipulators 2000 allows the at least two re-test chambers 1800 only to work in sequence, thus further improving testing efficiency. In addition, each re-test module includes its own buffer platform 1600, which increases the number of batteries that may be buffered and improves the processing capacity of the testing system.

In some embodiments, the re-test module further includes a re-test pairing platform 1700. The re-test manipulator 2000 is configured to grab the second compliant batteries into the re-test pairing platform 1700 to pair them into groups.

The re-test pairing platform 1700 pairs and groups the batteries that have passed the test of the re-test chamber 1800. This facilitates the grouping and unloading of compliant batteries, which improves unloading efficiency compared to unloading individual compliant batteries. For example, in some embodiments, four compliant batteries are unloaded in a group. The batteries that have passed the test of the re-test chamber 1800 will be grabbed by the re-test manipulator 2000 into the re-test pairing platform 1700 in sequence. Once the four compliant batteries are paired into a group, they will be unloaded together. For example, in a specific embodiment, the re-test pairing platform has a plurality of receiving slots configured to store batteries. The number of batteries stored is obtained by providing a sensor in the receiving slot. Once the batteries are grouped together, the manipulator may directly grab and unload the grouped battery packs.

The re-test module in the embodiments of the present application has a re-test pairing platform 1700 that is independent of the buffer platform 1600. This allows the buffer operation and the pairing operation to run independently, reducing conflicts in the action flow and improving the fault tolerance rate.

In some embodiments, the battery airtightness testing system further includes a first unloading manipulator 700 and a first-stage unloading conveyor belt 800. The first unloading manipulator 700 is configured to grab a second compliant battery pack onto the first-stage unloading conveyor belt 800 after a plurality of second compliant batteries are paired on the re-test pairing platform 1700 to form the second compliant battery pack.

Referring to FIG. 1, the re-test chamber 1800 performs a second airtightness test on the battery. The batteries that have passed the test are grabbed by the re-test manipulator 2000 into the re-test pairing platform 1700 to pair them into groups. Then, the first unloading manipulator 700 is configured to grab the grouped batteries onto the first-stage unloading conveyor belt 800.

The embodiments of the present application provide a re-test manipulator 2000 and a first-stage unloading manipulator 700 to perform the re-test and unloading operations respectively, which allows the re-test and unloading operations to be carried out in parallel, improving the overall production rhythm and production efficiency.

In some embodiments, the first unloading manipulator 700 is further configured to grab the first compliant battery pack onto the first-stage unloading conveyor belt 800 and grab the first non-compliant battery pack onto the buffer platform 1600.

The first unloading manipulator 700 transfers and transports batteries in groups. In other words, the first unloading manipulator 700 may transfer one incoming battery pack at a time. Specifically, the first unloading manipulator 700 includes a plurality of grabbing parts, each configured to grab one battery.

The first unloading manipulator 700 in the embodiments of the present application is configured to transfer the incoming battery pack which has undergone the first airtightness test to the next process according to the test results, which is a simple processing flow.

In some embodiments, the at least two re-test modules include a first re-test module and a second re-test module that are arranged opposite to each other.

The expression that the first re-test module and the second re-test module are arranged opposite to each other means that the first re-test module and the second re-test module are arranged in correspondence. For example, in the embodiment shown in FIG. 1, the buffer platform of the first re-test module and the buffer platform of the second re-test module are arranged opposite to each other. The re-test pairing platform of the first re-test module and the re-test pairing platform of the second re-test module are arranged opposite to each other. The re-test chamber of the first re-test module and the re-test chamber of the second re-test module are arranged opposite to each other.

The at least two re-test modules in the embodiments of the present application are arranged opposite to each other, which allows a compact structure of the battery airtightness testing system in the embodiments of the present application. Moreover, this ensures that the movement path of the first unloading manipulator remains basically the same regardless of whether the first non-compliant battery pack output from the initial test module 600 is transferred to the first re-test module for the second airtightness test or to the second re-test module for the second airtightness test, thereby reducing the complexity of the control method.

In some embodiments, the battery airtightness testing system further includes at least two non-compliant battery conveyor belts 1900. The at least two non-compliant battery conveyor belts 1900 are arranged in correspondence with the at least two re-test modules. The re-test manipulator 2000 is configured to grab the second non-compliant batteries onto the at least two non-compliant battery conveyor belts 1900.

The second non-compliant batteries are batteries that have been verified as non-compliant in airtightness by the two airtightness tests. The battery airtightness testing system in the embodiments of the present application provides at least two non-compliant battery conveyor belts 1900, each corresponding to one re-test module. This allows for flexible handling of batteries that have failed the test of the re-test module, increases the total buffer capacity, and enhances the waste disposal capacity.

In some embodiments, referring to FIG. 1, the initial test module 600 includes a plurality of initial test chambers 610. The plurality of initial test chambers 610 are provided in correspondence with a plurality of incoming battery packs so that each initial test chamber 610 is configured to perform a first airtightness test on the plurality of batteries in the incoming battery packs.

As shown in FIG. 1, the initial test module 600 includes a plurality of initial test chambers 610 that are provided independently. Each initial test chamber 610 may perform an independent airtightness test. Each initial test chamber 610 contains an incoming battery pack, i.e., a plurality of batteries. For example, in a specific embodiment, each initial test chamber 610 contains four batteries.

The initial test module 600 of the embodiments of the present application includes a plurality of initial test chambers 610, each corresponding to one incoming battery pack. In this way, a plurality of transported incoming battery packs may be transferred to the plurality of initial test chambers 610 for the first airtightness test, thereby improving the processing capacity of the battery airtightness testing system of the embodiments of the present application.

In some embodiments, the battery airtightness testing system includes at least two initial test modules and a loading manipulator 500. The at least two initial test modules include a first initial test module 600a and a second initial test module 600b. The loading manipulator 500 is configured to load a plurality of incoming battery packs into the first initial test module 600a and the second initial test module 600b, the second initial test module 600b being loaded only when the at least two initial test chambers of the first initial test module 600a are both full.

The loading manipulator 500 is configured to load a plurality of transported incoming battery packs into the at least two initial test modules for the first airtightness test. Since each initial test module includes a plurality of initial test chambers, it may test a plurality of incoming battery packs simultaneously. To ensure that the processing capacity of each initial test module is fully utilized, the capacity of the previous loaded initial test module is required to be determined during loading. Only when the previous loaded initial test module is full will the loading manipulator continue to load the next initial test module. This avoids the waste of processing capacity caused by vacancy space in the initial test chambers in the initial test modules. For example, in a specific embodiment, the initial test module 600 includes four initial test chambers 610. Therefore, only when all four initial test chambers 610 of the first initial test module 600a are filled with incoming battery packs, will the loading manipulator 500 load the next incoming battery pack into the second initial test module 600b.

In the embodiments of the present application, the loading manipulator 500 determines whether the first initial test module 600a is full before loading. Only when the first initial test module 600a is full will it load the second initial test module 600b. This avoids vacant space in the initial test chamber of the initial test module, thereby ensuring processing efficiency.

In some embodiments, the battery airtightness testing system further includes a compliant battery unloading conveyor belt 800. The compliant battery unloading conveyor belt 800 is configured to receive batteries that have passed the airtightness test. Batteries that have passed the airtightness test include a plurality of batteries from the first compliant battery pack and the second compliant battery.

In some embodiments, the battery airtightness testing system further includes a withstand voltage test conveyor belt 900 disposed downstream of the compliant battery unloading conveyor belt 800, a second unloading manipulator 1400, and an unloading pairing platform 1300. The withstand voltage test conveyor belt 900 is configured to perform a withstand voltage test (HIPOT test) on batteries that have passed the airtightness test. The second unloading manipulator 1400 is configured to grab at least two batteries from the withstand voltage test conveyor belt 900 and place the batteries that have passed the withstand voltage test on the unloading pairing platform 1300 according to the test results of the withstand voltage test conveyor belt 900. The unloading pairing platform 1300 is configured to receive batteries that have passed the withstand voltage test and pair them into groups.

Referring to FIG. 1, after the airtightness of the battery is tested, the compliant batteries will be placed on the compliant battery unloading conveyor belt 800. Furthermore, the batteries will undergo a withstand voltage test, also known as the HIPOT test, using the withstand voltage test conveyor belt 900. After the withstand voltage test, the batteries that have passed the test will be discharged. Batteries that have failed the withstand voltage test will be output by the NG pull belt. The expression that the second unloading manipulator is configured to grab at least two batteries from the withstand voltage test conveyor belt 900 means that the second unloading manipulator 1400 will directly grab a plurality of batteries from the withstand voltage test conveyor belt 900, including both batteries that have passed the withstand voltage test and batteries that have failed the withstand voltage test. Then, after grabbing, the second unloading manipulator 1400 moves to the unloading pairing platform 1300 and, based on the test results of the withstand voltage test conveyor belt 900, places the batteries that have passed the withstand voltage test onto the unloading pairing platform 1300, while grabbing the batteries that have failed the withstand voltage test onto the NG unloading pull belt. For example, in a specific embodiment, the second unloading manipulator 1400 includes four grabbing parts, so that the second unloading manipulator 1400 may directly grab four batteries from the withstand voltage test conveyor belt 900. If two of the batteries have passed the withstand voltage test, and the other two have failed the withstand voltage test. When the second unloading manipulator 1400 moves to a position above the unloading pairing platform 1300, the grabbing part configured to grab the battery that has passed the withstand voltage test may be controlled to open, thereby releasing the battery that has passed the withstand voltage test onto the unloading pairing platform 1300. The grabbing part configured to grab the battery that has failed the withstand voltage test continues to grab the batteries.

With the battery airtightness testing system of the embodiments of the present application, through the cooperation of the second unloading manipulator 1400 and the unloading pairing platform 1300, batteries that have passed the withstand voltage test are paired and buffered on the unloading pairing platform 1300, while batteries that have failed the withstand voltage test are directly disposed of by the second unloading manipulator 1400. This setting improves the effectiveness of the process and reduces the waste of the pull belt buffer position.

In some embodiments, the second unloading manipulator 1400 includes at least two grabbing parts disposed in correspondence with at least two batteries. At least two grabbing parts are arranged sequentially along the arrangement direction of the at least two batteries. The at least two batteries include a battery that has passed the withstand voltage test and a battery that has failed the withstand voltage test. The second unloading manipulator 1400 is configured to control the grabbing part configured to grab the battery that has passed the withstand voltage test to open and place the battery that has passed the withstand voltage test onto the unloading pairing platform 1300, and to control the grabbing part configured to grab the battery that has failed the withstand voltage test to close and continue grabbing batteries that have failed the withstand voltage test.

The second unloading manipulator 1400 in the embodiments of the present application simultaneously grabs a battery that has passed the withstand voltage test and a battery that has failed the withstand voltage test, thus avoiding repeated grabbing and improving efficiency. It also avoids buffering a battery that has failed the withstand voltage test on the pull belt, reducing the waste of pull belt buffer position.

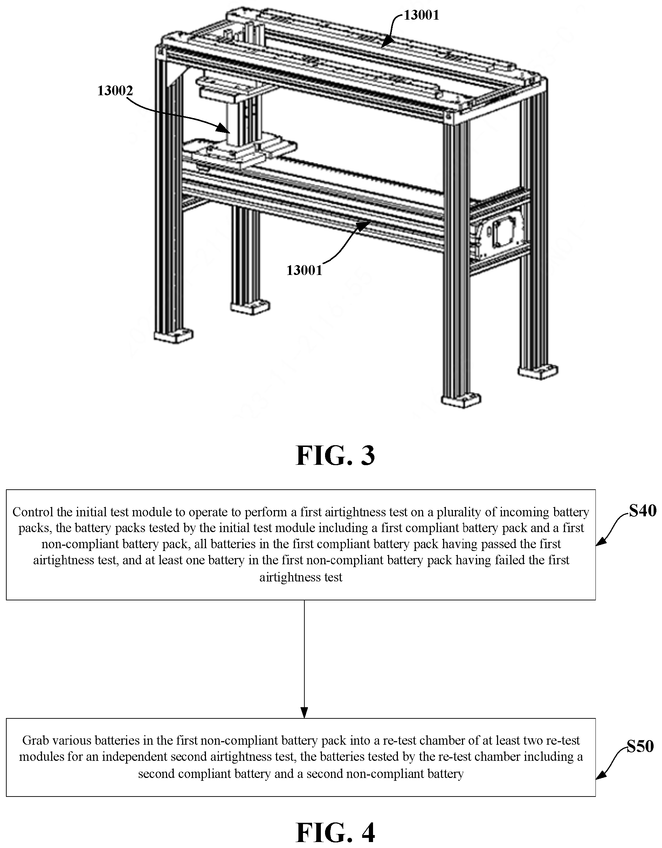

In some embodiments, referring to FIGS. 2 and 3, the unloading pairing platform 1300 includes a platform body 13001 and a lifting mechanism 13002. The platform body 13001 is configured to hold a battery that has passed the withstand voltage test placed by the second unloading manipulator 1400. When there is an empty space between a plurality of batteries that have passed the withstand voltage test, the lifting mechanism 13002 lifts at least some of the plurality of batteries that have passed the withstand voltage test upward and moves them laterally so that the plurality of batteries that have passed the withstand voltage test are arranged sequentially on the platform body 13001.

As described above, the second unloading manipulator 1400 simultaneously grabs batteries that have passed the withstand voltage test and batteries that have failed the withstand voltage test. Therefore, among the plurality of batteries simultaneously grabbed by the second unloading manipulator 1400, the at least two batteries that have passed the withstand voltage test are not necessarily all arranged adjacent to each other. Thus, when the second unloading manipulator 1400 controls the grabbing part to open and place at least two batteries that have passed the withstand voltage test onto the platform body 13001, there may be an empty space between the at least two batteries that have passed the withstand voltage test. When there is an empty space, a battery is required to be lifted and translated by the lifting mechanism 13002 so that the plurality of batteries placed on the platform body 13001 are placed adjacent to each other and arranged in order, thereby effectively pairing them into groups. It should be noted that the translation of the lifting mechanism 13002 is made in the arrangement direction of the batteries.

In another embodiment, the platform main body 13001 has a plurality of storage slots. The plurality of storage slots are configured to hold a plurality of batteries. If at least two batteries that have passed the withstand voltage test are not placed adjacent to each other, there will be an empty storage slot between the two batteries, which will affect the pairing of the batteries into groups. Therefore, in the embodiments of the present application, the pairing of the batteries in the platform body 13001 into groups is achieved by providing the lifting mechanism 13002.

The unloading pairing platform 1300 of the embodiments of the present application uses a lifting mechanism 13002 to lift and translate the batteries to fill the empty space in the platform main body 13001, thereby completing the ordering and pairing of a plurality of batteries to facilitate the battery pack discharge process.

In some embodiments, the battery airtightness testing system further includes a loading barcode scanning conveyor belt 200. The loading barcode scanning conveyor belt 200 is configured to scan the barcode of the batteries in the incoming battery packs before the incoming battery packs are loaded to the initial test module 600. After the barcode scanning process, the plurality of incoming battery packs are loaded to the initial test module 600.

The battery airtightness testing system of the embodiments of the present application performs barcode scanning on the incoming battery pack before loading. However, barcode-scanning based disposal is not performed on a battery that has failed the barcode scanning before loading. This avoids the waste of the process caused by barcode-scanning based disposal of the entire group of batteries if some batteries in the group have failed the barcode scanning. This alleviates the problem of low efficiency caused by repeated testing.

Referring to FIG. 1, in some embodiments, the battery airtightness testing system further includes a compliant battery unloading conveyor belt 800, a second unloading manipulator 1400, and an unloading pairing platform 1300. The compliant battery unloading conveyor belt 800 is configured to receive batteries that have passed the airtightness test. The second unloading manipulator 1400 is configured to transport the batteries that have passed the airtightness test according to the barcode scanning results of the loading barcode scanning conveyor belt 200. The second unloading manipulator 1400 transports the batteries that have passed barcode scanning to the unloading pairing platform 1300 to pair them into groups.

The battery airtightness testing system of the embodiments of the present application does not perform barcode-scanning based disposal immediately after scanning the barcode of the incoming battery pack. Instead, it performs barcode-scanning based disposal only on a battery that has passed the airtightness test. This avoids repeated testing and improves efficiency.

Referring to FIG. 4, the present application also provides a battery airtightness testing method based on the battery airtightness testing system of the above embodiments, comprising the following steps:
S40: controlling the initial test module 600 to operate to perform a first airtightness test on a plurality of incoming battery packs, the battery packs tested by the initial test module 600 including a first compliant battery pack and a first non-compliant battery pack, all batteries in the first compliant battery pack having passed the first airtightness test, and at least one battery in the first non-compliant battery pack having failed the first airtightness test; and
S50: grabbing various batteries in the first non-compliant battery pack into a re-test chamber 1800 of at least two re-test modules for an independent second airtightness test, the batteries tested by the re-test chamber 1800 including a second compliant battery and a second non-compliant battery.

In the battery airtightness testing method of the embodiments of the present application, at least two re-test modules are used to perform a second airtightness test on the batteries in the first non-compliant battery pack. The at least two re-test modules operate in parallel, thereby improving the re-test processing capability of the battery airtightness testing system and increasing production efficiency.

In some embodiments, the battery airtightness testing system includes a first initial test module and a second initial test module, and the battery airtightness testing method further includes loading a plurality of incoming battery packs into the first initial test module and the second initial test module, the second initial test module 600b being loaded only when at least two initial test chambers of the first initial test module 600a are both full.

In the embodiments of the present application, the loading manipulator 500 determines whether the first initial test module 600a is full before loading. Only when the first initial test module 600a is full will it load the second initial test module 600b. This avoids vacant space in the initial test chamber of the initial test module, thereby ensuring processing efficiency.

In some embodiments, the battery airtightness testing method includes scanning the barcode of various batteries in the incoming battery pack before loading the incoming battery pack into the initial test module.

The battery airtightness testing system of the embodiments of the present application performs barcode scanning on the incoming battery pack before loading. However, barcode-scanning based disposal is not performed on a battery that has failed the barcode scanning before loading. This avoids the waste of the process caused by barcode-scanning based disposal of the entire group of batteries if some batteries in the group have failed the barcode scanning. This alleviates the problem of low efficiency caused by repeated testing.

In some embodiments, the battery airtightness testing method further includes: after completing the second airtightness test, disposing of a battery that has failed the barcode scanning among the second compliant batteries according to the barcode scanning results of various batteries in the incoming battery pack.

The battery airtightness testing system of the embodiments of the present application performs barcode scanning on the incoming battery pack before loading. However, barcode-scanning based disposal is not performed on a battery that has failed the barcode scanning before loading. This avoids the waste of the process caused by barcode-scanning based disposal of the entire group of batteries if some batteries in the group have failed the barcode scanning. This alleviates the problem of low efficiency caused by repeated testing.

In some embodiments, the battery airtightness testing method further includes: after completing the second airtightness test, disposing of a battery that has failed the barcode scanning among the second compliant batteries according to the barcode scanning results of various batteries in the incoming battery pack.

The battery airtightness testing system of the embodiments of the present application does not perform barcode-scanning based disposal immediately after scanning the barcode of the incoming battery pack. Instead, it performs barcode-scanning based disposal only on a battery that has passed the airtightness test. This avoids repeated testing and improves efficiency.

The structure and operation process of the battery airtightness testing system according to a specific embodiment of the present application are described in detail below with reference to FIGS. 1 to 4.

As shown in FIG. 1, the battery airtightness testing system of this embodiment includes a loading rotation conveyor belt 100, a loading barcode scanning conveyor belt 200, a loading transfer conveyor belt 300, a loading conveyor belt 400, a loading manipulator 500, an initial test module 600, a first unloading manipulator 700, a first-stage unloading conveyor belt 800, a withstand voltage test conveyor belt 900, an unloading buffer conveyor belt 1000, an unloading rotation conveyor belt 1100, a buffer platform 1600, a re-test pairing platform 1700, a re-inspection chamber 1800, a re-inspection manipulator 2000, a non-compliant battery conveyor belt 1900, a second-stage unloading conveyor belt 1200, a second unloading manipulator 1400, an unloading pairing platform 1300, and a buffer unloading conveyor belt 1500. The battery airtightness testing system in this embodiment is configured to perform airtightness and withstand voltage tests on the battery after welding of the top cover is completed, and to recycle the batteries that have failed the tests.

The battery airtightness testing system in this embodiment includes two initial test modules, namely the first initial test module 600a and the second initial test module 600b. The initial test module 600 includes a plurality of initial test chambers 610. Each initial test chamber 610 is configured to perform a first airtightness test on an incoming battery pack.

The loading manipulator 500 is configured to load the incoming battery pack into the initial test chamber 610 of the initial test module 600. The loading manipulator 500 includes a plurality of grabbing parts that operate simultaneously to pick up a plurality of batteries from the incoming battery pack at the same time.

The first unloading manipulator 700 is configured to unload the incoming battery pack onto the first-stage unloading conveyor belt 800 or the buffer platform 1600 of the re-test module. Specifically, if the incoming battery pack is found to be the first compliant battery pack through test by the initial test module 600, the first unloading manipulator 700 will grab the incoming battery pack onto the first-stage unloading conveyor belt 800. If the incoming battery pack is found to be the first non-compliant battery pack through test by the initial test module 600, the first unloading manipulator 700 will grab the incoming battery pack onto the buffer platform 1600 of the re-test module to wait for re-test.

The re-test module includes a buffer platform 1600, a re-test pairing platform 1700, a re-test chamber 1800, and a re-test manipulator 2000. The re-test module is configured to perform a second airtightness test on the batteries of the battery pack that has failed the first airtightness test, i.e., the first non-compliant battery pack. After the first unloading manipulator 700 moves the first non-compliant battery pack to the buffer platform 1600, the re-test manipulator 2000 is configured to move the batteries of the first non-compliant battery pack into the re-test chamber 1800 for a second airtightness test. Furthermore, the re-test chamber 1800 tests each battery individually, thus the tested batteries are divided into second compliant batteries and second non-compliant batteries. The re-test manipulator 2000 is configured to transport the second non-compliant batteries to the non-compliant battery conveyor belt 1900 for waste (NG) disposal. The re-test manipulator 2000 is further configured to transport the second compliant batteries to the re-test pairing platform 1700 to pair them into groups. Then, the first unloading manipulator 700 transports the batteries that have been paired into groups from the re-test pairing platform 1700 to the first-stage unloading conveyor belt 800.

The first-stage unloading conveyor belt 800 carries batteries that have passed the airtightness test. Batteries that have passed the airtightness test are conveyed by the first-stage unloading conveyor belt 800 to the withstand voltage test conveyor belt 900 for the withstand voltage test. The batteries that have undergone the withstand voltage test arrive sequentially at the unloading rotation conveyor belt 1100 via the unloading buffer conveyor belt 1000. The second unloading manipulator 1400 is configured to transport various batteries to the second-stage unloading conveyor belt 1200 or the unloading pairing platform 1300 based on the results of the withstand voltage test. Specifically, the second unloading manipulator 1400 transports the batteries that have passed the withstand voltage test to the unloading pairing platform 1300 to pair them into groups. The second unloading manipulator 1400 transports batteries that have failed the withstand voltage test to the buffer unloading conveyor belt 1500 for waste disposal.

In this embodiment, the battery airtightness testing system is a battery helium testing system. Because helium is chemically stable, it is used to test the airtightness of battery casings.

Detailed description is made hereinafter of the entire operation process of the battery airtightness testing system provided in the present application according to this embodiment.

As shown in FIG. 1, the incoming battery pack consists of four incoming batteries as a group. The batteries, after the top cover welding is completed, are transported and loaded via the loading rotation conveyor belt 100, the loading barcode scanning conveyor belt 200, the loading transfer conveyor belt 300, and the loading conveyor belt 400. Then, the loading manipulator 500 transfers the batteries to the initial test chamber 610 of the initial test module 600 for the first airtightness test. If the incoming battery pack has passed the first airtightness test, it is the first compliant battery pack and is transferred by the first unloading manipulator 700 to the first-stage unloading conveyor belt 800. Then, it is transferred to the unloading rotation conveyor belt 1100 via the withstand voltage test conveyor belt 900 and the unloading buffer conveyor belt 1000.

If the incoming battery pack has failed the first airtightness test, it is considered the first non-compliant battery pack and will be transferred by the first unloading manipulator 700 to the buffer platform 1600. The buffer platform 1600 will then move laterally to the picking position of the re-inspection manipulator 2000, where it will be taken away by the re-inspection manipulator 2000 and placed into the re-test chamber 1800 for the second airtightness test. In this embodiment, the re-test chamber 1800 includes two independently provided chambers, each configured to perform a second airtightness test on the two batteries. If the two batteries in the re-test chamber 1800 have passed the re-inspection, they will be transferred by the re-test manipulator 2000 to the re-test pairing platform 1700 for pairing and buffering. After the pairing is completed, the pairing platform 1700 will move laterally to the unloading position and then the first unloading manipulator 700 will place the batteries into the first-stage unloading conveyor belt 800 for a normal discharge process. If there are both a battery that has passed the re-inspection and a battery that has failed the re-inspection in the re-test chamber 1800, the re-test manipulator 2000 will first transfer the battery that has failed the re-inspection to the non-compliant battery conveyor belt 1900 for waste disposal, and then the re-test manipulator 2000 will transfer the battery that has passed the re-inspection to the re-test pairing platform 1700 for pairing and buffering. Batteries that have failed the re-inspection will be directly transferred by the re-test manipulator 2000 to the non-compliant battery conveyor belt 1900 for waste disposal.

The unloading rotation conveyor belt 1100 sorts the incoming batteries based on barcode scanning or Hipot test results. If the result is success, it will move laterally and rotate to dock with the second-stage unloading conveyor belt 1200. After docking, the batteries will be transferred to the second-stage unloading conveyor belt 1200 to complete the discharge process.

If the result is failure, the rotation pull belt lateral movement servo motor assembly will move the batteries laterally to the transit position, where the second unloading manipulator 1400 will take them away. After the second unloading manipulator 1400 completes the picking, it sorts the four batteries according to the barcode scanning/Hipot test results. The second unloading manipulator 1400 first places the batteries that have passed the barcode scanning/Hipot test results into the unloading pairing platform 1300 for pairing and buffering. Then, it places the batteries that have failed the barcode scanning/Hipot test into the buffer unloading conveyor belt 1500 for waste disposal.

As shown in FIGS. 2 and 3, the unloading pairing platform 1300 includes the components of a platform body 13001, a lifting mechanism 13002, and a lateral movement drive mechanism 13003. The platform body 13001 is configured to receive batteries transported by the second unloading manipulator 1400 that have passed the barcode scanning/Hipot test. Then, the lifting mechanism 13002 lifts the batteries located in the platform body 13001. The lateral movement drive mechanism 13003 drives the lifting mechanism 13002 to fill the gaps in the platform body 13001 with batteries, order the four batteries in consecutive positions in the platform body 13001, and wait for the second unloading manipulator 1400 to take away the batteries, completing the pairing and discharging process.

When the unloading pairing platform 1300 completes the pairing, the unloading rotation conveyor belt 1100 will move laterally to the transit position, waiting for the second unloading manipulator 1400 to take away the batteries that have been paired by the unloading pairing platform 1300 and place them in the unloading rotation conveyor belt 1100. Then the unloading rotation conveyor belt 1100 will rotate them and dock with the second-stage unloading conveyor belt 1200 to complete the discharge process.

In this embodiment, the lifting mechanism 13002 is a lifting cylinder. The lateral movement drive mechanism 13003 is a servo motor.

Although the present application has been described with reference to the preferred embodiments, various modifications may be made thereto and components therein may be replaced with equivalents without departing from the scope of the present application. In particular, the technical features mentioned in the various embodiments may be combined in any manner as long as there is no structural conflict. The present application is not limited to the particular embodiments disclosed herein, but rather includes all technical solutions falling within the scope of the claims.

## Claims

1. A battery airtightness testing system, comprising:
an initial test module (600) configured to perform a first airtightness test on a plurality of incoming battery packs, each of which including a plurality of batteries, the battery packs tested by the initial test module (600) including a first compliant battery pack and a first non-compliant battery pack, all batteries in the first compliant battery pack having passed the first airtightness test, and at least one battery in the first non-compliant battery pack having failed the first airtightness test; and
at least two re-test modules including a buffer platform (1600), a re-test chamber (1800), and a re-test manipulator (2000); the buffer platform (1600) being configured to receive and store the first non-compliant battery pack; the re-test manipulator (2000) being configured to grab all batteries in the first non-compliant battery pack buffered in the buffer platform (1600) into the re-test chamber (1800); the re-test chamber (1800) being configured to perform an independent second airtightness test on each battery in the first non-compliant battery pack, the batteries tested by the re-test chamber (1800) including a second compliant battery and a second non-compliant battery.

2. The battery airtightness testing system according to claim 1, wherein the re-test module further comprises a re-test pairing platform (1700), and the re-test manipulator (2000) is configured to grab the second compliant batteries into the re-test pairing platform (1700) to pair them into groups.

3. The battery airtightness testing system according to claim 2, further comprising a first unloading manipulator (700) and a first-stage unloading conveyor belt (800), wherein the first unloading manipulator (700) is configured to grab a second compliant battery pack onto the first-stage unloading conveyor belt (800) after the plurality of second compliant batteries are paired on the re-test pairing platform (1700) to form the second compliant battery pack.

4. The battery airtightness testing system according to claim 3, wherein the first unloading manipulator (700) is further configured to grab the first compliant battery pack onto the first-stage unloading conveyor belt (800) and grab the first non-compliant battery pack onto the buffer platform (1600).

5. The battery airtightness testing system according to any one of claims 1 to 4, wherein the at least two re-test modules include a first re-test module and a second re-test module that are arranged opposite to each other.

6. The battery airtightness testing system according to any one of claims 1 to 5, further comprising at least two non-compliant battery conveyor belts (1900), which are provided in correspondence with the at least two re-test modules, wherein the re-test manipulator (2000) is configured to grab the second non-compliant batteries onto the at least two non-compliant battery conveyor belts (1900).

7. The battery airtightness testing system according to any one of claims 1 to 6, wherein the initial test module comprises a plurality of initial test chambers, which are provided in correspondence with the plurality of incoming battery packs so that each initial test chamber is configured to perform a first airtightness test on a plurality of batteries in the incoming battery packs.

8. The battery airtightness testing system according to claim 7, comprising the at least two initial test modules and a loading manipulator (500), wherein the at least two initial test modules comprise a first initial test module (600a) and a second initial test module (600b), and the loading manipulator (500) is configured to load the plurality of incoming battery packs into the first initial test module (600a) and the second initial test module (600b), the second initial test module (600b) being loaded only when the at least two initial test chambers of the first initial test module (600a) are both full.

9. The battery airtightness testing system according to claim 1, further comprising a compliant battery unloading conveyor belt (800), a withstand voltage test conveyor belt (900) disposed downstream of the compliant battery unloading conveyor belt (800), a second unloading manipulator (1400), and an unloading pairing platform (1300), wherein the compliant battery unloading conveyor belt (800) is configured to receive batteries that have passed the airtightness test, the batteries that have passed the airtightness test include a plurality of batteries in a first compliant battery pack and a second compliant battery, the withstand voltage test conveyor belt (900) is configured to perform a withstand voltage test on the batteries that have passed the airtightness test, the second unloading manipulator (1400) is configured to grab at least two batteries from the withstand voltage test conveyor belt (900) and place the batteries that have passed the withstand voltage test on the unloading pairing platform (1300) according to the test results of the withstand voltage test conveyor belt (900), and the unloading pairing platform (1300) is configured to receive the batteries that have passed the withstand voltage test and pair them into groups.

10. The battery airtightness testing system according to claim 9, wherein the second unloading manipulator (1400) comprises at least two grabbing parts arranged in correspondence with the at least two batteries, the at least two grabbing parts are arranged sequentially in the arrangement direction of the at least two batteries, the at least two batteries include a battery that has passed the withstand voltage test and a battery that has failed the withstand voltage test, the second unloading manipulator (1400) is configured to control the grabbing part configured to grab the battery that has passed the withstand voltage test to open and place the battery that has passed the withstand voltage test onto the unloading pairing platform (1300), and to control the grabbing part configured to grab the battery that has failed the withstand voltage test to close and continue grabbing batteries that have failed the withstand voltage test.

11. The battery airtightness testing system according to claim 10, wherein the unloading pairing platform (1300) comprises a platform body (13001) and a lifting mechanism (13002), the platform body (13001) is configured to hold a battery that has passed the withstand voltage test placed by the second unloading manipulator (1400), and when there is an empty space between a plurality of batteries that have passed the withstand voltage test, the lifting mechanism (13002) lifts at least some of the plurality of batteries that have passed the withstand voltage test upward and moves them laterally so that the plurality of batteries that have passed the withstand voltage test are arranged sequentially on the platform body (13001).

12. The battery airtightness testing system according to any one of claims 1 to 11, further comprising a loading barcode scanning conveyor belt (200), which is configured to scan the barcode of various batteries in an incoming battery pack before loading the incoming battery pack into the initial test module (600).

13. The battery airtightness testing system according to claim 12, further comprising a compliant battery unloading conveyor belt (800), a second unloading manipulator (1400), and an unloading pairing platform (1300), wherein the compliant battery unloading conveyor belt (800) is configured to receive batteries that have passed the airtightness test, the second unloading manipulator (1400) is configured to transport the batteries that have passed the airtightness test according to the barcode scanning result of the loading barcode scanning conveyor belt (200), and the second unloading manipulator (1400) transports the batteries that have passed barcode scanning to the unloading pairing platform (1300) to pair them into groups.

14. The battery airtightness testing system according to any one of claims 1 to 13, wherein the re-test chamber (1800) comprises at least two sub-retest chambers, each configured to perform an airtightness test on a single battery.

15. The battery airtightness testing system according to claim 2, wherein the re-test pairing platform (1700) comprises a plurality of receiving slots configured to store batteries; and
each receiving slot is provided with a sensor to detect the number of batteries stored in a corresponding receiving slot.

16. The battery airtightness testing system according to claim 4, wherein the first unloading manipulator (700) comprises a plurality of grabbing parts, each configured to grab one battery.

17. A battery airtightness testing method based on the battery airtightness testing system according to any one of claims 1 to 16, comprising the following steps:
controlling the initial test module to operate to perform a first airtightness test on a plurality of incoming battery packs, the battery packs tested by the initial test module (600) including a first compliant battery pack and a first non-compliant battery pack, all batteries in the first compliant battery pack having passed the first airtightness test, and at least one battery in the first non-compliant battery pack having failed the first airtightness test; and
grabbing various batteries in the first non-compliant battery pack into a re-test chamber (1800) of the at least two re-test modules for an independent second airtightness test, the batteries tested by the re-test chamber (1800) including a second compliant battery and a second non-compliant battery.

18. The battery airtightness testing method according to claim 17, wherein the battery airtightness testing system comprises a first initial test module and a second initial test module, and the battery airtightness testing method further comprises:
loading a plurality of incoming battery packs into the first initial test module and the second initial test module, the second initial test module (600b) being loaded only when at least two initial test chambers of the first initial test module (600a) are both full.

19. The battery airtightness testing method according to claim 17, comprising:
scanning the barcode of various batteries in the incoming battery pack before loading the incoming battery pack into the initial test module.

20. The battery airtightness testing method according to claim 19, further comprising:
after completing the second airtightness test, disposing of a battery that has failed the barcode scanning among the second compliant batteries according to the barcode scanning results of various batteries in the incoming battery pack.
